# EUROPEAN PATENT APPLICATION

(11) **EP 4 727 292 A1**
(43) Date of publication of application: **15.04.2026**
(21) Application number: 24205646.3
(22) Date of filing: 09.10.2024
(51) Int. Cl.: H10D 84/83, H03K 17/10, H03K 17/16

(54) **A SEMICONDUCTOR CHIP INCLUDING TRANSISTORS**

(71) Applicant: Infineon Technologies Austria AG, 9500 Villach (AT)
(72) Inventor: MODOLO, Nicola, 9500 Villach (AT); VITRENKO, Oleg, 9500 Villach (AT); DELLAS, Nicholas Stephen, 9500 Villach (AT); ZUNIGA, Marco, Berkeley, 94705 (US)
(74) Representative: Elkington and Fife LLP

(57) **Abstract**

A semiconductor chip comprising a plurality of first transistors and a plurality of second transistors is provided. The plurality of first transistors are configured such that they may be more robust than the second transistors against the application of high fields during turn on, such as those that may be experienced during hard switching. Specifically, the first transistors may have a larger gate to drain spacing, and/or may be designed to have additional barrier, passivation, and/or buffer layers. There is further provided control circuitry that, during turn on, controls the gate terminals of each of the first transistors to allow conduction between the respective drain terminals and source terminals before controlling the gate terminals of each of the second transistors to allow conduction between the respective drain terminals and source terminals. Furthermore, during turn off, the control circuitry controls the gate terminals of each of the second transistors to block conduction between the respective drain terminals and source terminals before controlling the gate terminals of each of the first transistors to block conduction between the respective drain terminals and source terminals. Accordingly, the first transistors and control scheme may ensure that the first and second transistors are collectively robust, whilst second transistors can be designed to suit other needs, such as a smaller footprint, smaller source-drain on resistance, lower cost and reduced complexity of the overall semiconductor chip.

## Description

### FIELD OF THE INVENTION

This invention relates in general to semiconductor chips, and in particular it relates to semiconductor chips comprising a plurality of transistors.

### BACKGROUND OF THE INVENTION

Power devices must be robust in expected use cases. That is, power devices must reliably perform as expected in normal applications conditions when in off-states, on-states and when switching between these states. While such devices tend to degrade over time, reliable operation must still be ensured over a satisfactory lifetime. Dynamic high temperature operating life (DHTOL) tests are often used for power devices to determine device reliability under application conditions.

Various field-effect transistors (FETs), such as gallium nitride (GaN) power transistors, are known to suffer from dynamic drain-source on-resistance (RDSon). This dynamic RDSon can lead to degradation of the transistor over time, particularly under hard-switching conditions. Ensuring that the transistors are robust against degradation is therefore key for ensuring that devices have a satisfactory lifetime.

Options for improving robustness of the transistor usually relate to manufacturing changes, the use of alternative materials, or the additional layers, all of which add cost to the device and complications in implementation. For example, barrier layers, buffer layers, field plates and passivation layers may be provided to improve robustness of the transistor against high fields.

Another common method to improve robustness of the transistor is to increase the gate to drain spacing (Lgd). However, increased Lgd is often undesirable as this increases a footprint of the transistor, as well as increasing static RDSon of the transistor. Thus, the Lgd of the transistor is usually carefully chosen to suit the given application.

Accordingly, there exists a present need for improving robustness of transistors on a semiconductor chip whilst ensuring delivering a desired density of transistors on the semiconductor chip and having an ideal RDSon.

### SUMMARY OF THE INVENTION

According to one aspect of the invention, there is provided a semiconductor chip.

The semiconductor chip comprises a plurality of first transistors, each configured such that conduction between a respective drain terminal and a respective source terminal is controlled by a voltage applied to the gate terminal. The semiconductor chip further comprises a plurality of second transistors, each configured such that conduction between a respective drain terminal and a respective source terminal is controlled by a voltage applied to the gate terminal.

The gate to drain spacing of each of the plurality of first transistors is greater than a gate to drain spacing of each of the plurality of second transistors; each of the plurality of first transistors comprise an additional buffer layer provided between a channel of the respective first transistor and a substrate of the semiconductor chip; each of the plurality of first transistors comprise an additional field plate provided over the channel of the respective first transistor; and/or each of the plurality of first transistors comprise an additional passivation layer covering at least a part of each of the first transistors.

The semiconductor chip further comprises control circuitry configured, during turn on, to control the gate terminals of each of the first transistors to allow conduction between the respective drain terminals and source terminals before controlling the gate terminals of each of the second transistors to allow conduction between the respective drain terminals and source terminals. The control circuitry is also configured, during turn off, to control the gate terminals of each of the second transistors to block conduction between the respective drain terminals and source terminals before controlling the gate terminals of each of the first transistors to block conduction between the respective drain terminals and source terminals.
may be gallium nitride, GaN, power switches.

Those skilled in the art will recognize additional features and advantages upon reading the following detailed description, and upon viewing the accompanying drawings.

### BRIEF DESCRIPTION OF THE DRAWINGS

The invention will now be described by way of example with reference to the accompanying drawings, in which:
Fig. 1 presents graphs showing transient signal flow of a first transistor and a second transistor during turn-on and turn-off according to an embodiment of the invention;
Fig. 2 presents a simplified circuit diagram of a proposed system according to an embodiment of the invention;
Fig. 3 presents a simplified circuit diagram of a semiconductor chip according to an embodiment of the invention;
Fig. 4 presents a simplified circuit diagram of another semiconductor chip according to an embodiment of the invention;
Fig. 5 depicts the operation the semiconductor chip of Fig. 3 during turn-on;
Fig. 6 presents graphs showing transient signal flow of a first transistor and a second transistor depicted in Fig. 3 during turn-on;
Fig. 7 depicts the operation the semiconductor chip of Fig. 3 during turn-off;
Fig. 8 presents graphs showing transient signal flow of a first transistor and a second transistor depicted in Fig. 3 during turn-off;
Fig. 9 presents a simplified circuit diagram of a further semiconductor chip according to an embodiment of the invention;

It should be noted that these figures are diagrammatic and not drawn to scale. Relative dimensions and proportions of parts of these figures have been shown exaggerated or reduced in size, for the sake of clarity and convenience in the drawings.

### DETAILED DESCRIPTION

A semiconductor chip comprising a plurality of first transistors and a plurality of second transistors is provided. The plurality of first transistors are configured such that they may be more robust than the second transistors against the application of high fields during turn on, such as those that may be experienced during hard switching. Specifically, the first transistors may have a larger gate to drain spacing, and/or may be designed to have additional barrier, passivation, and/or buffer layers. There is further provided control circuitry that, during turn on, controls the gate terminals of each of the first transistors to allow conduction between the respective drain terminals and source terminals before controlling the gate terminals of each of the second transistors to allow conduction between the respective drain terminals and source terminals. Furthermore, during turn off, the control circuitry controls the gate terminals of each of the second transistors to block conduction between the respective drain terminals and source terminals before controlling the gate terminals of each of the first transistors to block conduction between the respective drain terminals and source terminals. Accordingly, the first transistors and control scheme may ensure that the first and second transistors are collectively robust, whilst second transistors can be designed to suit other needs, such as a smaller footprint, smaller source-drain on resistance (RDSon), lower cost and reduced complexity of the overall semiconductor chip.

In one embodiment, a spacing between the gate terminal and the drain terminal of each first transistor is equal to a first distance, and of each second transistor by a second distance. The first distance is greater than the second distance. Accordingly, the first transistors and control scheme may ensure that the first and second transistors are collectively robust (by virtue of a larger gate to drain spacing, Lgd), whilst facilitating a smaller Lgd of the second transistors - thereby reducing an overall area occupied by the transistors.

The proposed semiconductor chip provides a first set of transistors that are robust, particularly in hard switching conditions. Specifically, only a part of the semiconductor chip is dedicated to a set of first transistors that robust in hard switching conditions, and therefore may be expected to have a long lifetime in expected operating conditions. This robustness may be achieved by a larger Lgd, additional layers, improved manufacturing (e.g., a more refined epitaxial process for forming the channel of the transistors), for example. Another part of the semiconductor chip is dedicated to a set of second transistors that may not be designed to be robust against hard switching conditions on their own, but may be designed to fulfill other requirements. That is, the second transistors are protected by the first transistors and the control scheme which ensure dissipation of energy during switching through the robust first transistors, such that the first transistors may be designed whilst prioritizing other needs. For example, the second transistors may have a smaller Lgd (and therefore occupy a smaller area and have a small RDSon). The second transistors may alternatively, or a additionally, be designed to be simpler (and cheaper) - by omitting passivation layers, buffer layers and field plates that are employed in the first transistors, or may have less stringent manufacturing requirements (e.g., a simpler and cheaper epitaxy process).

This combination of transistors is facilitated by control circuitry that ensures that the first transistors switch on before the second transistors, and that the first transistors switch off after the second transistors. Accordingly, the first transistors may undergo hard switching whilst the second transistors may undergo soft switching. As the first transistors are designed to be more robust, they may be expected to be more suited for undergoing hard switching. Thus, the first transistors and control circuitry protect the second transistors (which may degrade quickly under hard switching conditions due to, for example, their small gate to drain spacing), whilst the second transistors ensure that, for example, the overall area occupied by the transistors is reduced.

In other words, the first transistors and control scheme may ensure that the first and second transistors are collectively robust (by virtue of a, for example, a larger Lgd), whilst enabling a smaller Lgd, reduced RDSon, reduced cost, and/or reduced complexity of the second transistors. This is achieved by ensuring that the first transistors primarily dissipate switching losses, whilst the second transistors primarily dissipate conduction losses.

To be clear, transistors must be robust in normal operating conditions. In other words, they must operate as expected for a reasonable lifetime, with deterioration occurring at a slow rate. More specifically, transistors must be robust in their off-state, on-state and when transitioning between these states. Nevertheless, transistors tend to be weakest during turn-on, when there is simultaneous application of high electric field, and high current density/high power dissipation. This results in hot electron generation and trapping in the structure, which contributes to a significant dynamic RDSon increase.

To improve robustness of the transistor in this condition, various modifications may be made to the transistor. For example:
(i) a gate to drain spacing of the transistor may be increased. This decreases the electric field density. However, this results in an increase in static RDSon, as well as increasing the size of the transistor;
(ii) a barrier layer may be provided between a channel (i.e., an active region) of the transistor and a substrate on which it is placed. For example, if the active region is formed of GaN on a substate, such as a silicon substrate, then an AlGaN barrier layer may be provided. The AlGaN barrier layer may provide for electron confinement (i.e., helps to confine electrons in the GaN layer, reducing the likelihood of electron leakage and improving the transistor's current gain), mobility enhancement:
   (i.e., can enhance the mobility of electrons in the GaN layer by reducing scattering and improving the overall crystal quality) and for control of the threshold voltage (i.e., can be designed to control the threshold voltage of the transistor, allowing for more precise control over the device's switching characteristics);
(iii) a buffer layer may be provided between the channel (i.e., the active region) and the substrate). For example, the buffer layer may be a thin layer of GaN/AIGaN and AIN material. The buffer layer can help to reduce lattice mismatch between the substrate and the active region, can reduce defects, isolate the channel from the substrate and reduce overall crystal quality of the active region. Of course, a thickness and composition of the buffer layer may be designed to optimize transistor performance and improve robustness;
(iv) a field plate may be provided over the channel (i.e., active region) of the transistor. The field plate is usually provided in the form of a metal electrode that is deposited on top of the channel, typically in the vicinity of the gate terminal. The field plate is designed to modify the electric field distribution within the transistor, which helps to improve its performance and reliability. By carefully designing shape, size, and position of the field plate, the electric field can be optimized to reduce the risk of transistor breakdown, improve switching speed, and increase power handling capability;
(v) a passivation layer may be provided covering at least a part of the transistor. The passivation layer is typically a thin layer of insulating material, such as SiN or SiO2, on top of the channel and other exposed surfaces of the transistor. The passivation layer may serve several purposes: it may protect the transistor from environmental factors like moisture and contaminants, reduce surface leakage currents, and improve the overall reliability of the device.

Of course, in addition to these modifications various materials of the transistor may be carefully chosen to improve robustness. Furthermore, the epitaxy process may be improved. To be clear epitaxy refers to the growth of the channel of the transistor on the substrate. The epitaxial process allows for precise control over the thickness, composition, and crystal structure of the GaN layer, which is critical for achieving high-performance transistor characteristics. Thus, more care may be taken (e.g., more time and money spent in ensuring a reliable process) to improve robustness of the transistor.

Other means and methods for improving robustness of the transistor will be apparent to the skilled person. In any case, the invention provides a set of first transistors that are robust particularly in hard switching conditions by employing any, or any combination, of the above techniques. The invention also provides a set of second transistors which may not employ all, or any of the above techniques. In contrast, the second transistors may be optimized for reduced cost, complexity, size, and/or RDSon.

Overall, an aim of the invention is to pass lifetime reliability tests whilst enabling the optimization of other parameters. Lifetime reliability tests are failed if the gate dielectric, or epitaxy of the transistor breaks, or the transistor otherwise stops operating as expected (e.g., dynamic RDSon increases dramatically due to electron trapping).

Thus a control scheme is provided that defines a first set of transistors for hard switching. These first transistors may be robust in exchange for a greater Lds, higher RDSon, and greater complexity, for example. However, the control scheme defines a second set of transistors which undergo soft switching, and therefore only need to be robust in soft-switching conditions. That is, the first transistors may only need to be robust in on-state and off-state conditions. Accordingly, a semiconductor chip with an overall set of transistors may be provided that have a smaller footprint, reduced manufacturing complexity and cost, and a smaller average static RDSon.

In an exemplary embodiment of the present invention, it is proposed to provide only part of the semiconductor chip with transistors having a conservative (i.e., larger) Lgd to improve overall robustness of the chip, whilst the rest of the chip may have transistors with an aggressively scaled (i.e., smaller) Lgd to reduce the footprint of the transistors. Accordingly, the average static RDSon of the transistors may be reduced, and an occupied area may be reduced, whilst still providing transitors that are robust in hard switching conditions.

In other words, only a small fraction of the transistors of the semiconductor chip are dedicated to hard-switching, whilst the remainder of the transistors only undergo soft-switching. This combination is enabled by control circuitry that creates a delay in a gate propagation signal between the transistors having the conservative Lgd (i.e., first transistors), and the transistors having the aggressively scaled Lgd (i.e., second transistors).

A key advantage of embodiments of the proposed invention is that dynamic high temperature operating lifetime (DHTOL) robustness requirements may be handled without requiring each transistor to be capable of being robust against hard switching (e.g., without each transistor having a conservative Lgd, and/or buffer/barrier/passivation/field plate layers to handle such requirements). As this advantage is facilitated by the control circuitry, rather than by changing processes in manufacture of the transistors or by increasing Lgd of all of the transistors, there may be reduced cost whilst simultaneously providing a semiconductor chip having transistors with a small footprint and low RDSon.

In some cases, some transistors may be a gallium nitride (GaN) based power switches. Such devices are known to suffer from dynamic RDSon under hard switching conditions, and therefore an improvement of the robustness of such devices is desirable. A typical approach to improving robustness is to increase the Lgd of the switches, however this greatly increases the area occupied by the devices. The invention thus enables the provision of a collection of GaN power switches on a semiconductor chip that are collectively robust in hard-switching conditions, whilst having a smaller overall footprint. Nevertheless, embodiments are not limited hereto, and the transistor may also be a silicon based power switch, or any other transistor type.

By way of example, each of the plurality of first transistors may have an Lgd of 3.4µm, and each of the plurality of second transistors may have an Lgd of 2.2µm. Accordingly, each of the first transistors may be robust in DHTOL conditions, whilst each of the second transistors may be optimized for RDSon and area occupied. In this case, 30% of the transistors on the semiconductor chip may be first transistors and 70% of the transistors on the semiconductor chip may be second transistors. This may result in a 30% to 40% improvement in RDSon*Area occupied by the overall chip.

Of course, the above example is simply intended to demonstrate the potential advantages of the proposed invention. The ratio of first transistors to second transistors may be modified based on the application of the semiconductor chip, or other desired parameters of operation.

It should also be noted that, should the ratio of second transistors to first transistors be increased (for example, to 5% first transistors and 95% second transistors), the second transistors may no longer experience purely soft switching. That is, the small number of first transistors may not be able to dissipate all of the charge (between the gate and source) fast enough before the second transistors begin turning on. The turn-on time may be extended, but this will result in higher switching losses. Furthermore, as the proportion of second transistors to first transistors increases, the improvement in RDSon*Area occupied by the overall chip may diminish (i.e., RDSon*Area may not improve by a significant amount). This may nevertheless be suitable for some cases where the second transistors are robust enough (e.g., have a large enough Lgd) to withstand some degree of hard switching.

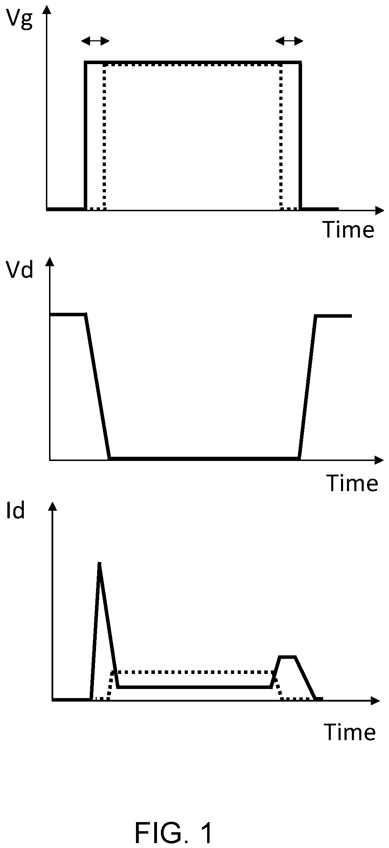

Fig. 1 presents graphs showing various parameters of the first transistor and the second transistor during turn-on and turn-off of the transistors. That is, the top graph presents the gate voltage on each of the first transistors (solid line) and each of the second transistors (dotted line). The middle graph presents the drain-source voltage of all of the transistors. The bottom graph shows the drain-source current of each of the first transistors (solid line) and each of the second transistors (dotted line).

As can be seen, the gate of each of the first transistors is controlled, by the control circuitry, to reach a gate voltage (i.e., a voltage required for turning on the transistor) for a time before the gate of each of the second transistors is controlled, by the control circuitry, to reach the gate voltage. Thus, the first transistors are turned on before the second transistors. In the time between the first transistors being turned on, and the second transistors being turned on, the drain-source voltage may be reduced, for example to a ground voltage or near ground voltage. As a result, the first transistors will experience a peak in the drain-source current, before returning to a nominal value once all of the second transistors are turned on.

In other words, it can be seen that the control circuitry controls the gate terminals of each of the first transistors to allow conduction between the respective drain terminals and source terminals before controlling the gate terminals of each of the second transistors to allow conduction between the respective drain terminals and source terminals. In effect, this means that each of the first transistors may experience hard switching, whilst each of the second transistors will experience soft switching, during turn on.

As can also be seen, the gate voltage is removed from each of the second transistors by the control circuitry, for a time before the gate voltage is removed from of each of the first transistors by the control circuitry. Thus, the second transistors are turned off before the first transistors.

Put another way, it can also be seen that the control circuitry controls the gate terminals of each of the second transistors to block conduction between the respective drain terminals and source terminals before controlling the gate terminals of each of the first transistors to block conduction between the respective drain terminals and source terminals. In effect, this means that each of the first transistors may experience hard switching, whilst each of the second transistors will experience soft switching, during turn off.

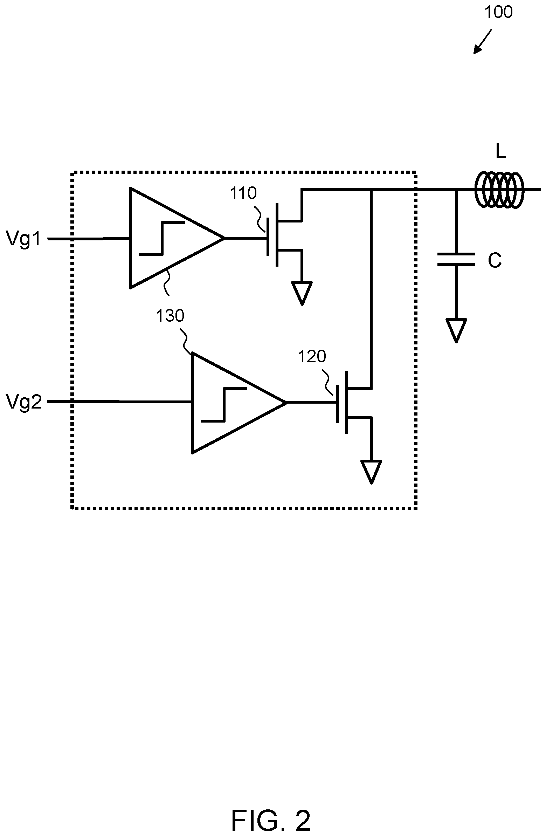

Turning to Fig. 2, there is presented a simplified circuit diagram of a proposed system 100 according to an embodiment of the invention.

As seen, the semiconductor chip 100 comprises a first transistor 110 and a second transistor 120. It should be noted that, whilst only one first transistor 110, and one second transistor 120 is depicted here, there may be a large number of each transistor type. In addition, there may be an unequal amount of first transistors 110 and second transistors 120. For example, there may be three first transistors 110 for every seven second transistors 120.

Each transistor comprises a drain terminal, a source terminal, and a gate terminal. As is well understood, conduction between the drain terminal and the source terminal of each transistor is controlled by a voltage applied to the gate terminal. If the gate terminal is provided with at least a gate voltage, then the transistor effectively acts as a short circuit between source and drain. If the gate terminal is provided with less than a gate voltage (e.g., a ground voltage), then the transistor effectively acts as an open circuit between source and drain.

According to the invention, the first transistors 110 are more robust than the second transistors 120 in hard switching conditions. Specifically, the first transistors 110 are more robust against simultaneous application of high electric fields and high current density. Thus, the first transistors 110 may be able to dissipate more power than the second transistors 120 whilst still operating as expected/prescribed.

In particular, a gate to drain spacing of each of the plurality of first transistors 110 may be greater than a gate to drain spacing of each of the plurality of second transistors 120; each of the plurality of first transistors 110 may comprise an additional buffer layer (compared to the second transistors 120, which may not have a buffer layer or may have a less effective buffer layer) provided between a channel of the respective first transistor and a substrate of the semiconductor chip, each of the plurality of first transistors 110 may comprise an additional field plate (compared to the second transistors 120, which may not have a field plate or may have a less effective field plate) provided over the channel of the respective first transistor; and/or each of the plurality of first transistors 110 may comprise an additional passivation layer (compared to the second transistors 120, which may not have a passivation layer or may have a less effective passivation layer) covering at least a part of each of the first.

Any combination of these factors for increasing robustness of the first transistors 110 compared to the second transistors 120 may be applied. There may also be other differences between the first transistors 110 and the second transistors 120. For example, the first transistors 110 may be manufactured using a more complicated and/or expensive procedure that ensures consistency of the channel of the transistors and the reduction of defects.

In one embodiment, the spacing between the gate terminal and the drain terminal of each first transistor 110 is equal to a first distance. A spacing between the gate terminal and the drain terminal of each second transistor 120 is equal to a second distance. The first distance is greater than the second distance. Indeed, it may be the case that both the first transistors 110 and second transistors 120 comprise buffer layers, barrier layers, passivation layers and field plates. That is, the only difference between the transistors may be a difference in the gate to drain spacing, with the first transistors 110 having a greater spacing than the second transistors.

In some cases, the first distance may be selected such that each of the first transistors 110 is robust over a significant lifetime (i.e., maintains a reliable performance after operating for a long amount of time). That is, the spacing between the gate terminal and drain terminal of each first transistor is selected such that the first transistor may not degrade quickly whilst operating in normal conditions (such that the transistor does not allow conduction during hard switching in given voltage and environmental conditions).

Furthermore, the second distance may be selected such that each of the second transistors 120 have a minimized RDSon multiplied by unit area occupied by the second transistor. That is, the spacing between the gate terminal and drain terminal of each second transistor is selected such that the second transistor is as small as possible whilst still having a small enough RDSon. Indeed, as the distance decreases, RDSon generally increases, and therefore a there is a tradeoff to achieve a minimal RDSon * unit area occupied. As will be well understood, this optimization depends on the specifics of the transistor.

To be clear, at least some of the first transistors 110 and/or the second transistors 120 may be GaN power switches, Si power switches, or any other type of transistor.

The semiconductor chip 100 may further comprise control circuitry 130, either mounted on the semiconductor chip 100 or provided as a separate component.

The control circuitry 130 is configured, during turn on, to control the gate terminals of each of the first transistors 110 to allow conduction between the respective drain terminals and source terminals before controlling the gate terminals of each of the second transistors 120 to allow conduction between the respective drain terminals and source terminals. More specifically, during turn on, the control circuitry 130 may be configured to apply a gate voltage to the gate terminals of the first transistors 110 before applying the gate voltage to the gate terminals of the second transistors 120.

Furthermore, during turn off, the control circuitry 130 is configured to control the gate terminals of each of the second transistors 120 to block conduction between the respective drain terminals and source terminals before controlling the gate terminals of each of the first transistors 110 to block conduction between the respective drain terminals and source terminals. In particular, during turn off, the control circuitry 130 may be configured to apply a ground voltage to the gate terminals of each of the second transistors 120 before applying the ground voltage to the gate terminals of each of the first transistors 110.

As seen in Fig. 2, the control circuitry 130 may comprise a first gate driver 132 configured to control the gate terminals of the first transistors 110. Thus, the first gate driver ensures that the first transistors 110 are turned on before the second transistors 120, and waits to turn off the first transistors 110 until after the second transistors 120 are turned off.

Furthermore, the control circuitry 130 may comprise a second gate driver configured to control the gate terminals of the second transistors 120. Thus, the second gate driver ensures that the first transistors 110 are turned on after second transistors 120 are turned on, and waits to turn off the first transistors 110 until after the second transistors 120 are turned off.

Accordingly, the first gate driver and the second gate driver provide a controlled delay in order to appropriately control the first transistors 110 and second transistors 120.

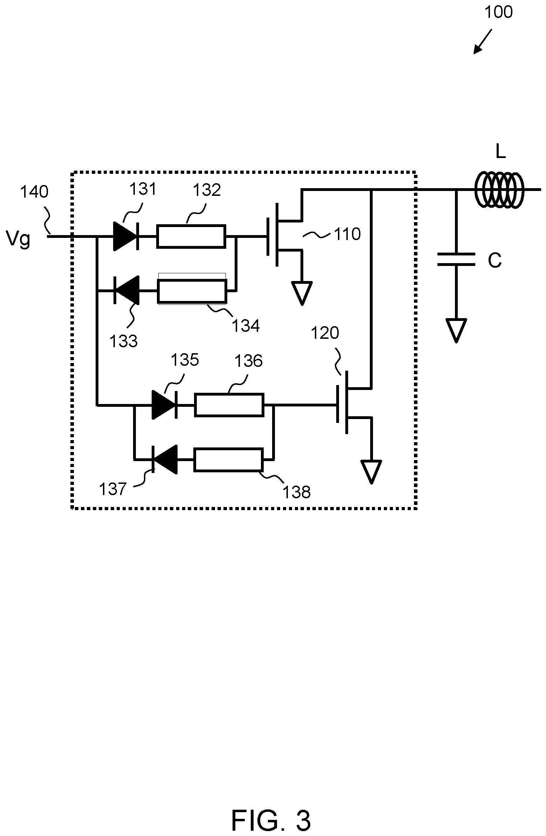

Fig. 3 presents a simplified circuit diagram of a semiconductor chip 100 according to an embodiment of the invention. Repeated description of the first transistors 110 and second transistors 120 will be omitted for the sake of brevity. In contrast to Fig. 2, Fig. 3 depicts control circuitry 130 that may be used to propagate a gate control voltage, Vg, to the first transistors 110 and second transistors 120 differently (rather than gate drivers used to appropriately control the gates of the transistors).

As seen, the control circuity comprises an input node 140 configured to receive a voltage, Vg, for application to the gate terminals of the first transistors 110 and the gate terminals of the second transistors 120. As this only a single control voltage is to be received, this may appear to be a simple one terminal control mechanism for the plurality of transistors to an external user.

The control circuitry 130 further comprises a first propagation circuit configured, when the received voltage changes from a ground voltage to a gate voltage, to instantaneously apply the received voltage to the gate terminals of the first transistors 110 and, when the received voltage changes from the gate voltage to a ground voltage, to delay application of the received voltage to the gate terminals of the first transistors 110.

In particular, the first propagation circuit comprises a first diode 131 connected between the input node 140 and the gate terminals of the first transistors 110, and configured to allow flow of current from the input node 140 to the gate terminals. The first propagation circuit further comprises a first resistor 134 connected between the input node 140 and the gate terminals of the first transistors 110, and in parallel with the first diode 131. The first resistor 134 may slow/impede the propagation of the signal from the input node 140 during turn off, thus delaying turn off of the first transistors 110.

A further (optional) diode 133 and resistor 132 may be provided on the opposite propagation paths to their counterparts 131 and 134, with the resistor 134 being configured to have lower resistance than first resistor 132. Of course, the respective resistances may be tuned to achieve the desired propagation delay. Operation of the first propagation circuit during turn on and turn off will be described in more detail below.

Additionally, the control circuitry 130 further comprises a second propagation circuit configured, when the received voltage changes from a ground voltage to a gate voltage, to delay application of the received voltage to the gate terminals of the second transistors 120; and when the received voltage changes from the gate voltage to a ground voltage, to instantaneously apply the received voltage to the gate terminals of the second transistors 120.

Specifically, the second propagation circuit comprises a second diode 137 connected between the input node 140 and the gate terminals of the second transistors 120 and configured to allow flow of current from the gate terminals to the input node 140. The second propagation circuit further comprises a second resistor 136 connected between the input node 140 and the gate terminals of the second transistors 120, and in parallel with the second diode. The second resistor 136 may slow/impede the propagation of the signal from the input node 140 during turn on, thus delaying turn on of the second transistors 120.

A further (optional) diode 135 and resistor 138 may be provided on the opposite propagation paths to their counterparts 136 and 137, with the resistor 138 being configured to have lower resistance than second resistor 136. Of course, the respective resistances may be tuned to achieve the desired propagation delay. Operation of the second propagation circuit during turn on and turn off will be described in more detail below.

It should also be noted that the depicted propagation circuits are meant by way of example only. Any other configuration capable of delaying signal propagation in one direction, and permitting near-instantaneous propagation in the other direction may be considered.

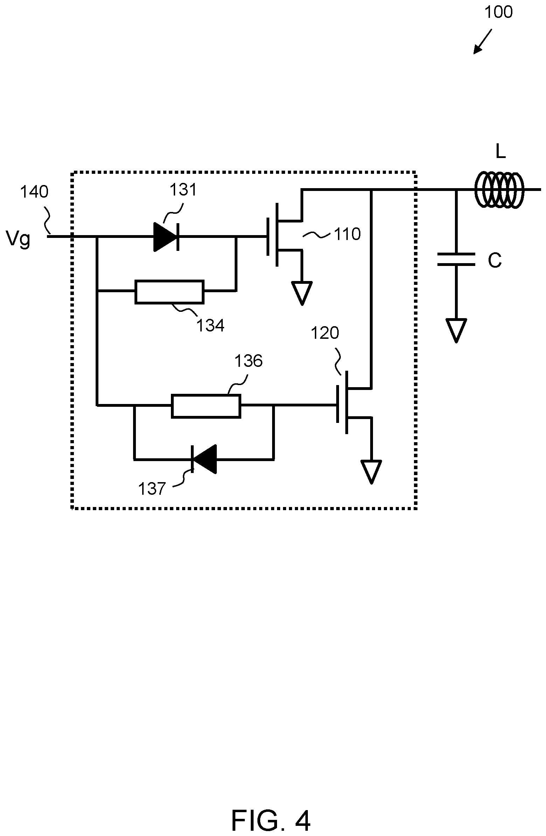

Fig. 4 presents a simplified circuit diagram of another semiconductor chip 100 according to an embodiment of the invention. Specifically, the semiconductor chip 100 in this example does not comprise the optional diodes 133 and 135, and the optional resistors 132 and 138 included in the device of Fig. 3.

Accordingly, the first propagation circuit consists of the first diode 131 and the first resistor 134. The second propagation circuit consists of the second diode 137 and the second resistor 136.

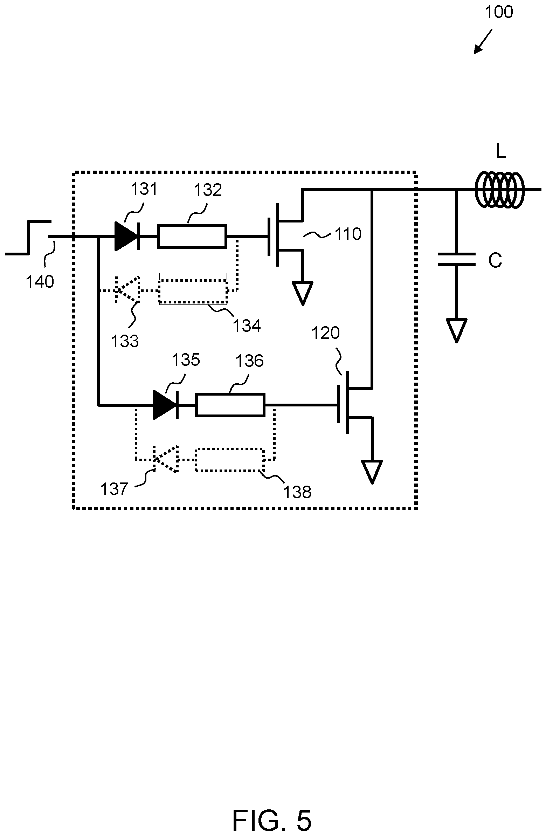

Fig. 5 depicts the operation the semiconductor chip 100 of Fig. 3 during turn-on.

During turn on, the first propagation circuit effectively only comprises the first diode 131. This is because the first diode 131 does not impede signal propagation, whilst the other propagation path comprises the first resistor 134 that impedes signal propagation (or even a diode 133 to prevent propagation in that direction). At the same time, the second propagation circuit effectively only comprises the second resistor 136, as the parallel propagation path comprises a diode 137 impeding propagation of the signal from the input node 140. As the second resistor 136 will have a higher resistance than the first diode 131 (and optional additional resistor 132), the on signal from the input node 140 will be applied to the first transistors 110 before the second transistors 120.

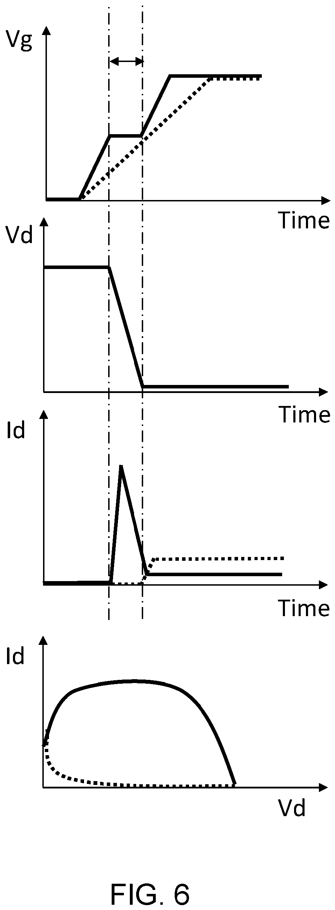

This is further demonstrated in Fig. 6, which presents graphs showing various parameters of a first transistor and a second transistor depicted in Fig. 3 during turn-on. As can be seen, the voltage applied to the gate of the first transistors 110 (solid line) rises faster than that of the gate of the second transistors 120 (dotted line). The first gate-source voltage then reaches the miller plateau until the volage on the drain terminals reaches a threshold voltage (i.e., a charge is dispersed). By virtue of the control circuitry 130 presented in Fig. 5, the voltage applied to the gate terminals of the second transistors 120 remains below the miller voltage until the voltage on the drain terminals reaches this threshold voltage.

In other words, during turn on, the voltage applied to the gate terminals of the second transistors 120 is controlled by the control circuitry 130 such that the applied voltage is less than a gate plateau voltage whilst a voltage on respective drain terminals of the second transistors 120 is above a gate threshold voltage of the second transistors 120. Thus, turn on of the second transistors 120 is slowed down in order to wait for the Miller plateau.

As a result, the second transistors 120 may experience soft switching, with the first transistors 110 experiencing hard switching. This is best seen in the bottom graph of Fig. 6, depicting the locus of the drain-source voltage against drain-source current as experienced by the first transistors 110 (solid line) and the second transistors 120. It can be seen from this graph that the first transistors 110 experience hard switching, with power being dispersed by the first transistors 110, therefore requiring the first transistors 110 to be robust to avoid breakdown. In contrast, current only begins flowing between drain and source of the second transistors 120 once the drain and source voltage has been equalised, so the second transistors 120 experience soft switching.

Of course, it should be noted that this is only the case when the charge has been dissipated by the first transistors 110 fast enough. This will depend on the number of first transistors 110 compared to the number of second transistors 120, as well as the delay implemented by the control circuitry 130. In some circumstances (e.g., when there are many second transistors 120, and too few first transistors 110), the second transistors 120 may experience some level of hard switching, albeit less than that of the first transistors 110.

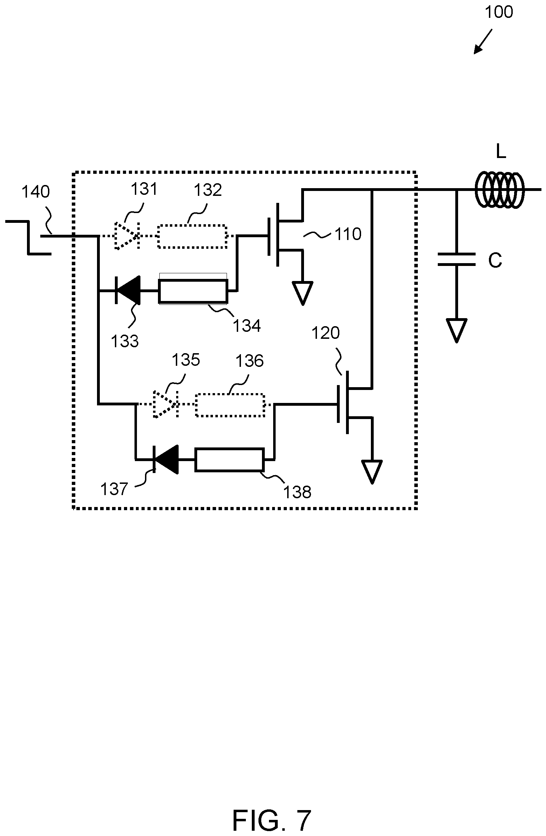

Fig. 7 depicts the operation the semiconductor chip 100 of Fig. 3 during turn-off.

During turn off, the first propagation circuit effectively only comprises the first resistor. This is because the first diode 131 impedes signal propagation

During turn off, the first propagation circuit effectively only comprises the first resistor 134, as the parallel propagation path comprises a diode 131 impeding propagation of the signal from the input node 140. The second propagation circuit effectively only comprises the second diode 137. This is because the second diode 137 does not impede signal propagation, whilst the other propagation path comprises the second resistor 136 that impedes signal propagation (and/or even a diode 135 to prevent propagation). As the first resistor 134 will have a higher resistance than the second diode 137 (and optional additional resistor 138), the off signal from the input node 140 will be applied to the second transistors 120 before the first transistors 110. Thus, the second transistors 120 will be turned off before the first transistors 110.

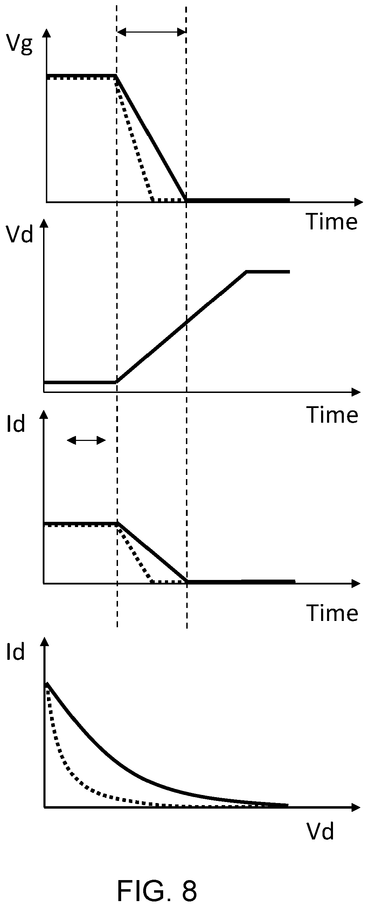

This is further demonstrated in Fig. 8, which presents graphs showing various parameters of a first transistor and a second transistor depicted in Fig. 3 during turn-off. As can be seen, the voltage applied to the gate of the second transistors 120 (dotted line) falls faster than that of the gate of the second transistors 120 (solid line). Therefore, the second transistors 120 are turned off before the first transistors 110 are turned off.

As a result, the second transistors 120 may experience soft switching, with the first transistors 110 experiencing hard switching. This is best seen in the bottom graph of Fig. 8, depicting the locus of the drain-source voltage against drain-source current as experienced by the first transistors 110 and the second transistors 120.

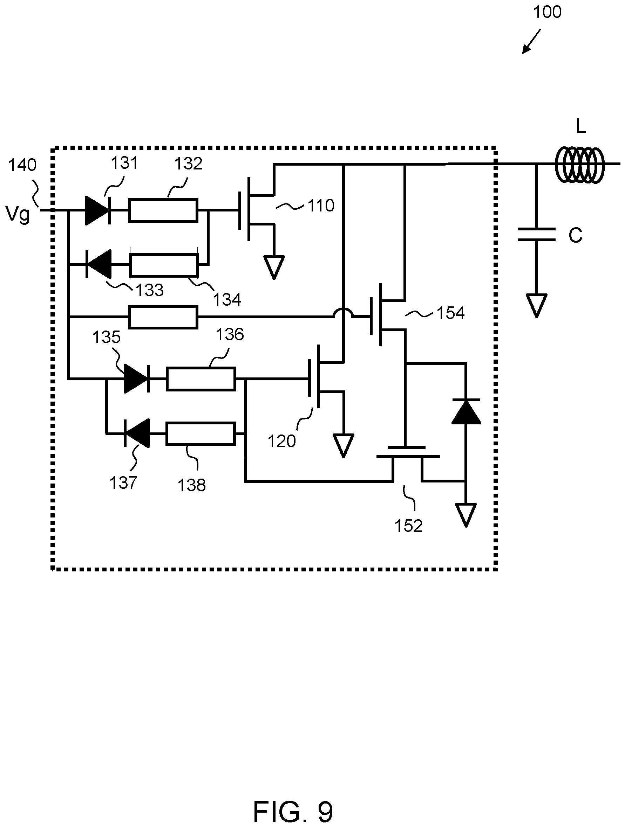

Fig. 9 presents a simplified circuit diagram of a further semiconductor chip 100 according to an embodiment of the invention.

As alluded to above, if the charge between the source and drain is not dissipated by the first transistors 110 fast enough (e.g., due to a small number of first transistors 110, not enough time allowed for dissipation, etc.), then the second transistors 120 may experience hard switching. In order to mitigate this, a pull down circuit may be provided, such as the pull down circuit depicted in Fig. 9, to ensure that the gate voltage of the second transistors 120 is kept at a ground voltage (i.e., the second transistors 120 are kept in an off-state) until the drain-source voltage drops below a threshold voltage.

In other words, the control circuitry 130 further comprises a pull down circuit configured, during turn on, to hold the gate terminals of the second transistors 120 at a ground voltage until a voltage on respective drain terminals of the second transistors 120 is below a gate threshold voltage of the second transistors 120.

In the presented implementation, the pull down circuit comprises a first switch 152 connected between the gate terminals of the second transistors 120 and ground, and a second switch 154 connected between the gate terminal of the first switch and the drain terminals of the first and second transistors 120. The gate of the second switch is connected to the input node 140. Of course, this is meant by way of example only, and other means for clamping the gate terminal of the second transistors 120 to a desired value may be provided.

In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The embodiments may be implemented by means of hardware comprising several distinct elements. In a device claim enumerating several means, several of these means may be embodied by one and the same item of hardware. The mere fact that certain measures are recited in mutually different dependent claims does not indicate that a combination of these measures cannot be used. Furthermore in the appended claims lists comprising "at least one of: A; B; and C" should be interpreted as (A and/or B) and/or C.

The following embodiments are disclosed:
1. A semiconductor chip, comprising:
   a plurality of first transistors, each configured such that conduction between a respective drain terminal and a respective source terminal is controlled by a voltage applied to the gate terminal;
   a plurality of second transistors, each configured such that conduction between a respective drain terminal and a respective source terminal is controlled by a voltage applied to the gate terminal,
   wherein:
      a gate to drain spacing of each of the plurality of first transistors is greater than a gate to drain spacing of each of the plurality of second transistors;
      each of the plurality of first transistors comprise an additional buffer layer provided between a channel of the respective first transistor and a substrate of the semiconductor chip;
      each of the plurality of first transistors comprise an additional field plate provided over the channel of the respective first transistor; and/or
      each of the plurality of first transistors comprise an additional passivation layer covering at least a part of each of the first transistors; and
   control circuitry configured:
      during turn on, to control the gate terminals of each of the first transistors to allow conduction between the respective drain terminals and source terminals before controlling the gate terminals of each of the second transistors to allow conduction between the respective drain terminals and source terminals;
      during turn off, to control the gate terminals of each of the second transistors to block conduction between the respective drain terminals and source terminals before controlling the gate terminals of each of the first transistors to block conduction between the respective drain terminals and source terminals.
2. The semiconductor chip of claim 1, wherein the gate to drain spacing of each of the plurality of first transistors is greater than the gate to drain spacing of each of the plurality of second transistors.
3. The semiconductor chip of embodiment 1 or 2, wherein each of the plurality of second transistors are smaller than each of the plurality of first transistors.
4. The semiconductor chip of any of embodiments 1-3, wherein the control circuitry is configured:
   during turn on, to apply a gate voltage to the gate terminals of the first transistors before applying the gate voltage to the gate terminals of the second transistors; and
   during turn off, to apply a ground voltage to the gate terminals of each of the second transistors before applying the ground voltage to the gate terminals of each of the first transistors.
5. The semiconductor chip of embodiment 4, wherein the control circuitry is configured:
   during turn on, to apply the voltage the gate terminals of the second transistors such that the applied voltage is less than a gate plateau voltage whilst a voltage on respective drain terminals of the second transistors is above a gate threshold voltage of the second transistors.
6. The semiconductor chip of any of embodiments 1-5, wherein the control circuitry comprises:
   a first gate driver configured to control the gate terminals of the first transistors; and
   a second gate driver configured to control the gate terminals of the second transistors.
7. The semiconductor chip of any of embodiments 1-5, wherein the control circuitry comprises:
   an input node configured to receive a voltage for application to the gate terminals of the first transistors and the gate terminals of the second transistors ;
   a first propagation circuit configured, when the received voltage changes from a ground voltage to a gate voltage, to instantaneously apply the received voltage to the gate terminals of the first transistors and, when the received voltage changes from the gate voltage to a ground voltage, to delay application of the received voltage to the gate terminals of the first transistors;
   a second propagation circuit configured, when the received voltage changes from a ground voltage to a gate voltage, to delay application of the received voltage to the gate terminals of the second transistors; and when the received voltage changes from the gate voltage to a ground voltage, to instantaneously apply the received voltage to the gate terminals of the second transistors.
8. The semiconductor chip of embodiment 7, wherein the first propagation circuit comprises:
   a first diode connected between the input node and the gate terminals of the first transistors, and configured to allow flow of current from the input node to the gate terminals; and
   a first resistor connected between the input node and the gate terminals of the first transistors, and in parallel with the first diode.
9. The semiconductor chip of embodiment 7 or 8, wherein the second propagation circuit comprises:
   a second diode connected between the input node and the gate terminals of the second transistors and configured to allow flow of current from the gate terminals to the input node; and
   a second resistor connected between the input node and the gate terminals of the second transistors, and in parallel with the second diode.
10. The semiconductor chip of any of embodiments 1-9, wherein the control circuitry further comprises a pull down circuit configured, during turn on, to hold the gate terminals of the second transistors at a ground voltage until a voltage on respective drain terminals of the second transistors is below a gate threshold voltage of the second transistors.
11. The semiconductor chip of any of embodiments 1-10, wherein at least some of the first transistors and/or the second transistors are gallium nitride, GaN, power switches.
12. The semiconductor chip of any of embodiments 1-11, wherein the semiconductor chip comprises at least seven second transistors for every three first transistors.
13. The semiconductor chip of any of embodiments 1-12, wherein the control circuitry is integrated on the same part of the semiconductor chip as the first transistors and second transistors, or is provided as a separate part of the semiconductor chip.

## Claims

1. A semiconductor chip (100), comprising:
a plurality of first transistors (110), each configured such that conduction between a respective drain terminal and a respective source terminal is controlled by a voltage applied to the gate terminal;
a plurality of second transistors (120), each configured such that conduction between a respective drain terminal and a respective source terminal is controlled by a voltage applied to the gate terminal,
wherein:
a gate to drain spacing of each of the plurality of first transistors is greater than a gate to drain spacing of each of the plurality of second transistors;
each of the plurality of first transistors comprise an additional buffer layer provided between a channel of the respective first transistor and a substrate of the semiconductor chip;
each of the plurality of first transistors comprise an additional field plate provided over the channel of the respective first transistor; and/or
each of the plurality of first transistors comprise an additional passivation layer covering at least a part of each of the first transistors; and
control circuitry (130) configured:
during turn on, to control the gate terminals of each of the first transistors to allow conduction between the respective drain terminals and source terminals before controlling the gate terminals of each of the second transistors to allow conduction between the respective drain terminals and source terminals;
during turn off, to control the gate terminals of each of the second transistors to block conduction between the respective drain terminals and source terminals before controlling the gate terminals of each of the first transistors to block conduction between the respective drain terminals and source terminals.

2. The semiconductor chip of claim 1, wherein the gate to drain spacing of each of the plurality of first transistors (110) is greater than the gate to drain spacing of each of the plurality of second transistors (120).

3. The semiconductor chip of claim 1 or 2, wherein each of the plurality of second transistors (120) are smaller than each of the plurality of first transistors (110).

4. The semiconductor chip of any of claims 1-3, wherein the control circuitry (130) is configured:
during turn on, to apply a gate voltage to the gate terminals of the first transistors (110) before applying the gate voltage to the gate terminals of the second transistors (120); and
during turn off, to apply a ground voltage to the gate terminals of each of the second transistors before applying the ground voltage to the gate terminals of each of the first transistors.

5. The semiconductor chip of claim 4, wherein the control circuitry (130) is configured:
during turn on, to apply the voltage the gate terminals of the second transistors (120) such that the applied voltage is less than a gate plateau voltage whilst a voltage on respective drain terminals of the second transistors is above a gate threshold voltage of the second transistors.

6. The semiconductor chip of any of claims 1-5, wherein the control circuitry (130) comprises:
a first gate driver configured to control the gate terminals of the first transistors (110); and
a second gate driver configured to control the gate terminals of the second transistors (120).

7. The semiconductor chip of any of claims 1-5, wherein the control circuitry (130) comprises:
an input node (140) configured to receive a voltage for application to the gate terminals of the first transistors (110) and the gate terminals of the second transistors (120);
a first propagation circuit configured, when the received voltage changes from a ground voltage to a gate voltage, to instantaneously apply the received voltage to the gate terminals of the first transistors and, when the received voltage changes from the gate voltage to a ground voltage, to delay application of the received voltage to the gate terminals of the first transistors;
a second propagation circuit configured, when the received voltage changes from a ground voltage to a gate voltage, to delay application of the received voltage to the gate terminals of the second transistors; and when the received voltage changes from the gate voltage to a ground voltage, to instantaneously apply the received voltage to the gate terminals of the second transistors.

8. The semiconductor chip of claim 7, wherein the first propagation circuit comprises:
a first diode (131) connected between the input node (140) and the gate terminals of the first transistors (110), and configured to allow flow of current from the input node to the gate terminals; and
a first resistor (134) connected between the input node and the gate terminals of the first transistors, and in parallel with the first diode.

9. The semiconductor chip of claim 7 or 8, wherein the second propagation circuit comprises:
a second diode (137) connected between the input node (140) and the gate terminals of the second transistors (120) and configured to allow flow of current from the gate terminals to the input node; and
a second resistor (136) connected between the input node and the gate terminals of the second transistors, and in parallel with the second diode.

10. The semiconductor chip of any of claims 1-9, wherein the control circuitry (130) further comprises a pull down circuit (150) configured, during turn on, to hold the gate terminals of the second transistors (120) at a ground voltage until a voltage on respective drain terminals of the second transistors is below a gate threshold voltage of the second transistors.

11. The semiconductor chip of any of claims 1-10, wherein at least some of the first transistors (110) and/or the second transistors (120) are gallium nitride, GaN, power switches.

12. The semiconductor chip of any of claims 1-11, wherein the semiconductor chip comprises at least seven second transistors (120) for every three first transistors (110).

13. The semiconductor chip of any of claims 1-12, wherein the control circuitry (130) is integrated on the same part of the semiconductor chip as the first transistors (110) and second transistors (120), or is provided as a separate part of the semiconductor chip.

## Amended claims

### Amended claims in accordance with Rule 137(2) EPC.

1. A semiconductor chip (100), comprising:
a plurality of first transistors (110), each configured such that conduction between a respective drain terminal and a respective source terminal is controlled by a voltage applied to the gate terminal;
a plurality of second transistors (120), each configured such that conduction between a respective drain terminal and a respective source terminal is controlled by a voltage applied to the gate terminal,
wherein the source terminals of each of the first transistors and the source terminals of each of the second transistors are connected together, and the drain terminals of each of the first transistors and the drain terminals of each of the second transistors are connected together; and
control circuitry (130) configured:
during turn on, to control the gate terminals of each of the first transistors to allow conduction between the respective drain terminals and source terminals before controlling the gate terminals of each of the second transistors to allow conduction between the respective drain terminals and source terminals;
during turn off, to control the gate terminals of each of the second transistors to block conduction between the respective drain terminals and source terminals before controlling the gate terminals of each of the first transistors to block conduction between the respective drain terminals and source terminals, and
**characterized in that**:
each of the plurality of first transistors comprise an additional buffer layer compared to each of the second transistors, each additional buffer layer provided between a channel of the respective first transistor and a substrate of the semiconductor chip;
each of the plurality of first transistors comprise an additional field plate compared to each of the second transistors, each additional field plate provided over the channel of the respective first transistor; and/or
each of the plurality of first transistors comprise an additional passivation layer compared to each of the second transistors, each additional passivation layer covering at least a part of each of the first transistors..

2. The semiconductor chip of claim 1, wherein the control circuitry (130) is configured:
during turn on, to apply a gate voltage to the gate terminals of the first transistors (110) before applying the gate voltage to the gate terminals of the second transistors (120); and
during turn off, to apply a ground voltage to the gate terminals of each of the second transistors before applying the ground voltage to the gate terminals of each of the first transistors.

3. The semiconductor chip of claim 1 or 2, wherein the control circuitry (130) comprises:
a first gate driver configured to control the gate terminals of the first transistors (110); and
a second gate driver configured to control the gate terminals of the second transistors (120).

4. The semiconductor chip of any of claims 1-3, wherein the control circuitry (130) comprises:
an input node (140) configured to receive a voltage for application to the gate terminals of the first transistors (110) and the gate terminals of the second transistors (120);
a first propagation circuit configured, when the received voltage changes from a ground voltage to a gate voltage, to instantaneously apply the received voltage to the gate terminals of the first transistors and, when the received voltage changes from the gate voltage to a ground voltage, to delay application of the received voltage to the gate terminals of the first transistors;
a second propagation circuit configured, when the received voltage changes from a ground voltage to a gate voltage, to delay application of the received voltage to the gate terminals of the second transistors; and when the received voltage changes from the gate voltage to a ground voltage, to instantaneously apply the received voltage to the gate terminals of the second transistors.

5. The semiconductor chip of claim 4, wherein the first propagation circuit comprises:
a first diode (131) connected between the input node (140) and the gate terminals of the first transistors (110), and configured to allow flow of current from the input node to the gate terminals; and
a first resistor (134) connected between the input node and the gate terminals of the first transistors, and in parallel with the first diode.

6. The semiconductor chip of claim 4 or 5, wherein the second propagation circuit comprises:
a second diode (137) connected between the input node (140) and the gate terminals of the second transistors (120) and configured to allow flow of current from the gate terminals to the input node; and
a second resistor (136) connected between the input node and the gate terminals of the second transistors, and in parallel with the second diode.

7. The semiconductor chip of any of claims 1-6, wherein the control circuitry (130) further comprises a pull down circuit (150) configured, during turn on, to hold the gate terminals of the second transistors (120) at a ground voltage until a voltage on respective drain terminals of the second transistors is below a gate threshold voltage of the second transistors.

8. The semiconductor chip of any of claims 1-7, wherein at least some of the first transistors (110) and/or the second transistors (120) are gallium nitride, GaN, power switches.

9. The semiconductor chip of any of claims 1-8, wherein the semiconductor chip comprises at least seven second transistors (120) for every three first transistors (110).
